# EUROPEAN PATENT APPLICATION

(11) **EP 4 746 300 A1**
(43) Date of publication of application: **20.05.2026**
(21) Application number: 25216115.3
(22) Date of filing: 17.11.2025
(51) Int. Cl.: H03M 1/06, H03M 1/46, H03M 1/80

(54) **SUCCESSIVE APPROXIMATION REGISTER ANALOG-TO-DIGITAL CONVERTER**

(30) Priority: 19.11.2024 CN 202411657741
(71) Applicant: NXP B.V., 5656 AG Eindhoven (NL)
(72) Inventor: ZHANG, Yizhong, 5656AG Eindhoven (NL); BERENS, Michael Todd, 5656AG Eindhoven (NL); JIN, Jie, 5656AG Eindhoven (NL); MO, Yikun, 5656AG Eindhoven (NL)
(74) Representative: Hardingham, Christopher Mark

(57) **Abstract**

An SAR ADC configured to convert a received analog input signal into a digital output signal comprising: a DAC configured to convert the received analog signal into a DAC output signal; a pre-amplifier circuit comprising a plurality of serially arranged preamplifiers; a primary latch comparator configured to compare a received final preamplifier output signal to a primary reference voltage to generate a primary latch output signal; a secondary latch comparator configured to compare a received preamplifier output signal to a secondary reference voltage to generate a secondary latch output signal; an SAR engine configured to receive the latch output signals from the primary and secondary latch comparators and configured to generate a digital output code representative of the analog input signal, wherein the SAR engine is configured to use one of the latch output signals to determine each bit of the plurality of bits and wherein the SAR engine is configured to use the secondary latch output signal to determine at least the MSB.

## Description

### Field

The present disclosure relates to a successive approximation register analog-to-digital converter (SAR ADC) configured to convert a received analog input signal into a digital output signal comprising a plurality of bits. The present disclosure further relates to a device comprising the SAR ADC.

### Summary

According to a first aspect of the present disclosure, there is provided a successive approximation register analog-to-digital converter (SAR ADC) configured to convert a received analog input signal into a digital output signal comprising a plurality of bits, the plurality of bits comprising bits from a Most Significant Bit (MSB) to a Least Significant Bit (LSB) comprising: a digital-to-analog converter (DAC) configured to convert the received analog signal into an DAC output signal; a pre-amplifier circuit comprising a plurality of serially arranged pre-amplifiers, wherein: each preamplifier is configured to apply a gain to a signal received at its input node; a first pre-amplifier of the plurality of preamplifiers is configured to receive the DAC output signal from the DAC at its input node and provide a first pre-amplifier output signal at an output node of the first pre-amplifier; each other preamplifier of the plurality of preamplifiers is configured to receive an output signal from the preceding preamplifier in the serially arranged plurality of preamplifiers; and a final preamplifier of the plurality of preamplifiers is configured to provide a final preamplifier output signal at an output node of the preamplifier circuit; a primary latch comparator configured to receive the final preamplifier output signal from the output node of the pre-amplifier circuit and wherein the primary latch comparator is configured to compare the received final preamplifier output signal to a primary reference voltage and wherein the primary latch comparator is further configured to generate a primary latch output signal based on the comparison; a secondary latch comparator configured to receive a preamplifier output signal from one of the plurality of pre-amplifiers other than the final preamplifier and wherein the secondary latch comparator is configured to compare the received preamplifier output signal to a secondary reference voltage and wherein the secondary latch comparator is further configured to generate a secondary latch output signal based on the comparison; an SAR engine configured to receive the primary latch output signal from the primary latch comparator and the secondary latch output signal from the secondary latch comparator and further configured to generate a digital output code representative of the analog input signal based on the primary latch output signal and the secondary latch output signal, wherein the SAR engine is configured to use only one of the latch output signals to determine each bit of the plurality of bits and wherein the SAR engine is configured to use the secondary latch output signal to determine at least the MSB.

In one or more embodiments, the secondary latch comparator may be configured to receive the first preamplifier signal from the first preamplifier.

In one or more embodiments, the SAR engine may be configured to use the secondary latch output signal to determine the I most significant bits of the plurality of bits wherein I is greater than one and less than the number of bits in the plurality of bits.

In one or more embodiments, the pre-amplifier circuit may further comprise at least three pre-amplifiers; the SAR ADC may further comprise a tertiary latch comparator configured to receive a preamplifier output signal from a preamplifier later in the serially arranged plurality of preamplifiers that is arranged after the preamplifier from which the secondary latch comparator receives a preamplifier output signal and wherein the tertiary latch comparator is configured to compare the received preamplifier output signal to a tertiary reference voltage; and wherein the tertiary latch comparator is further configured to generate a tertiary latch output signal based on the comparison; and wherein the tertiary latch comparator may be configured to provide the tertiary latch output signal to the SAR engine for the J next-most significant bits, wherein M is equal to at least equal to 1 and wherein M is at most equal to N-I , wherein N is equal to the number of bits in the plurality of bits.

In one or more embodiments, for each bit for which the SAR engine uses the secondary latch output signal, one or more of the pre-amplifiers arranged after the preamplifier from which the preamplifier output signal may be received by the secondary latch comparator are configured to operate in a low-power mode.

In one or more embodiments, for each bit for which the SAR engine uses the secondary latch output signal, current may be diverted from one or more of the preamplifiers that are configured to operate in a low-power mode to the secondary latch comparator
In one or more embodiments, for each bit for which the SAR engine uses the tertiary latch output signal, one or more of the pre-amplifiers arranged after the preamplifier from which the preamplifier output signal may be received by the tertiary latch comparator are configured to operate in a low-power mode.

In one or more embodiments, each latch comparator may be configured to compare the received amplified output signal to a respective reference voltage over one or more clock cycles in order to generate the latch output signal, wherein the primary latch comparator compares the received amplified output signal to the primary reference voltage over more clock cycles than the secondary latch comparator compares the received amplified output signal to the secondary reference voltage.

In one or more embodiments, the DAC may comprise one or more redundant bits.

In one or more embodiments, the DAC may be a capacitive digital-to-analog converter.

In one or more embodiments, the SAR engine may be an asynchronous SAR engine.

According to a second aspect of the present disclosure, there is provided a device comprising the SAR ADC of any preceding claim.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of an SAR ADC of the present disclosure;
Figure 2 shows an example capacitive digital-to-analog converter;
Figure 3 shows another example timing diagram of an SAR ADC of the present disclosure; and
Figure 4 shows an example device comprising the SAR ADC of the present disclosure.

### Detailed Description

SAR ADCs are popular for their high resolution and accuracy. Figures of Merit (FoMs) can be used for quick comparison between similar ADCs. FoMs can provide insights into trade-offs between various parameters such as power consumption, signal bandwidth and spectral purity. FoMs can also be used to highlight performance trends and to point to architectural strengths and shortcomings. One such FoM is equal to SNDR_{dB} + 10* log(2f_{sig}/P). SNDR_{dB} is the signal-to-noise and distortion ratio measured in decibels. This term quantifies the quality of the ADC's output by comparing the power of the desired signal to the power of noise and distortion components. f_{sig} is the frequency of the input analog signal being converted by the ADC. P denotes the power consumption of the ADC. The comparators of the SAR ADCs typically dominate power consumption. The number of clock cycles used for conversion and the clock frequency impact conversion speed itself. Typical ADC solutions suffer from an effect in which power and speed are limited by the conversion of the least significant bit.

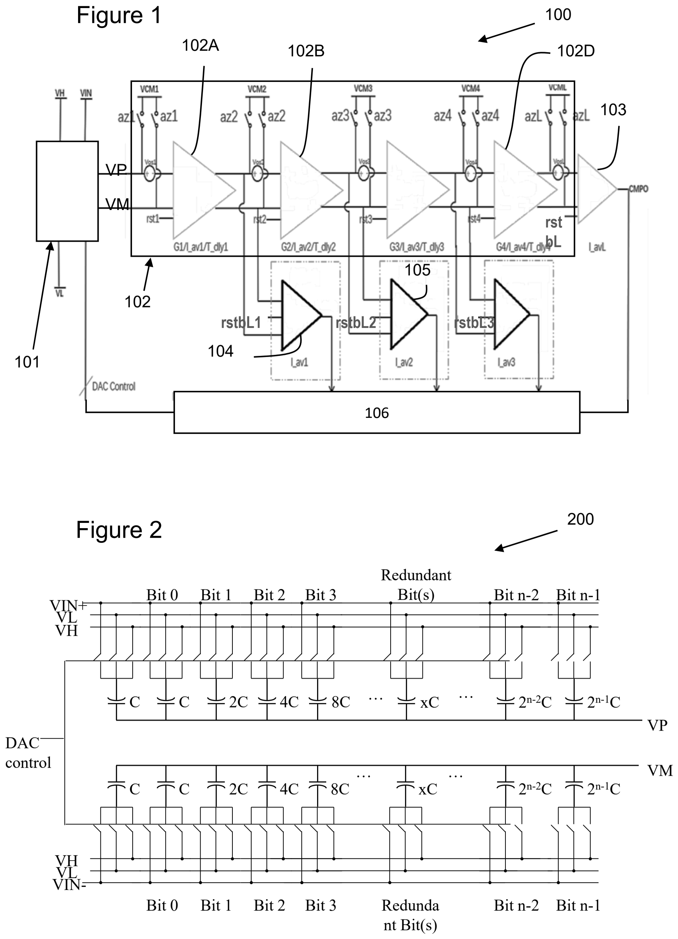

Figure 1 shows an example SAR ADC 100 configured to convert a received analog input signal to a digital output signal comprising a plurality of bits according to the present disclosure. The plurality of bits comprises bits from a Most Significant Bit (MSB) to a Least Significant Bit (LSB). For example, the SAR ADC 100 may be configured to convert an analog signal (VIN) (such as an instantaneous held value of an analog signal) into a digital output code, which is a digital signal representative of the analog input signal. The number of bits may be selected based on the implementation but may be, for example, 8 bit or 12 bit.

The SAR ADC 100 comprises a digital to analog converter (DAC) 101 which is configured to convert a received analog signal into a DAC output signal. In one or more embodiments, the DAC may be a capacitive digital to analog converter (CDAC). Other DAC types, such as resistor DAC (RDAC), could also be used. The DAC 101 may further receive one or more reference voltages (VH, VL) used in the SAR ADC 100 and the input voltage VIN.

The DAC 101 may provide for sample and hold of the analog input voltage. Sample and hold of the received analog input voltage may be performed in any suitable way, such as by a capacitor array.

Figure 2 shows an example CDAC 200 in which capacitors are able to sample and hold the input voltage and do successive approximation using bits from Bit n-1 to Bit 0. The DAC may comprise one or more redundant bits. The redundant bits may allow for reducing or eliminating any loss in accuracy from offset errors which may be introduced through the use of different preamplifiers and latch combinations. While the example embodiment depicted in figure 2 shows a differential DAC, a single ended DAC may be used in other embodiments.

Returning to figure 1, the SAR ADC 100 further comprises a preamplifier circuit 102 comprising a plurality of serially preamplifiers wherein each amplifier is configured to apply a gain to a signal received at its input node. Each preamplifier comprises an input node configured to receive a signal and an output node from which an output signal of the preamplifier is provided. The gain may be any suitable gain that provides for an increase in the input signal amplitude. A first preamplifier 102A of the plurality of preamplifiers is configured to receive the DAC output signal from the DAC 101 at its input node. The first preamplifier 102A further provides a first pre-amplifier output signal at its output node. Each preamplifier other than the first preamplifier 102A is configured to receive an output signal from the preceding preamplifier in the serially arranged plurality of preamplifiers and provide a respective output signal at its output node. A final preamplifier 102D of the plurality of preamplifiers is configured to provide a final preamplifier output signal at an output node of the preamplifier circuit 102.

The plurality of preamplifiers may comprise two preamplifiers, three, four or any other suitable number of preamplifiers needed in order to provide for the required signal amplification. In embodiments wherein the plurality of preamplifiers comprises two preamplifiers, the first preamplifier is the first preamplifier and the second preamplifier is the final preamplifier.

In one or more embodiments, each preamplifier may provide for amplification of an input signal received at its input node based on a difference between the input signal and a reference voltage. The reference voltage may be a reference voltage generated by the DAC 101.

The SAR ADC 100 further comprises a primary latch comparator 103 configured to receive the final preamplifier output signal from the output node of the pre-amplifier circuit 102. The primary latch comparator 103 is configured to compare the received final preamplifier output signal to a primary reference voltage and, based on the comparison, the primary latch comparator 103 is configured to generate a primary latch output signal. The primary latch output signal may be a digital signal, such as a binary signal, which indicates whether the input signal is higher or lower than the reference voltage.

The SAR ADC 100 also comprises a secondary latch comparator 104 configured to receive a preamplifier output signal from one of the plurality of preamplifiers other than the final preamplifier of the plurality of preamplifiers. The secondary latch comparator 104 is configured to compare the received first preamplifier output signal to a secondary reference voltage and, based on the comparison, the secondary latch comparator 104 is configured to generate a secondary latch output signal. The secondary latch output signal may be a digital signal, such as a binary signal, which indicates whether the input signal is higher or lower than the reference voltage.

The secondary latch comparator may be arranged between two of the preamplifiers of the plurality of preamplifiers. In instances where the signal amplitude of the preamplifier output signal output by the preamplifier arranged directly before the secondary latch comparator 104 is sufficiently large, the secondary latch comparator 104 may be used to generate the secondary latch output signal instead of using the primary latch comparator 103. Taking this approach allows the preamplifiers after the preamplifier which provides the preamplifier output signal to the secondary latch comparator to be turned off or operated in a low power mode. Operation of one or more of the preamplifiers in a low power mode may comprise reducing a current provided to the preamplifiers. In one or more examples when one or more of the preamplifiers is operating in a lower power mode, current may be diverted from one or more of the preamplifiers that are configured to operate in the low power mode to the secondary latch comparator 104. By providing for this current diversion, the secondary latch comparator 104 may be able to improve the operation of the secondary comparator output signal. Providing for the current diversion may reduce the latch comparator's response time and, thereby allow it to make decisions faster. This may improve the overall speed of the SAR ADC 100, enabling higher sampling rates.

In one or more embodiments, the secondary latch comparator 104 may be configured to receive the first preamplifier signal from the first preamplifier 102A. That is, the secondary latch comparator 104 may be arranged between the first preamplifier 102A and the second preamplifier 102B of the plurality of preamplifiers. It will be appreciated that, in other embodiments, the secondary latch comparator 104 may be arranged between any other two of the serially arranged plurality of preamplifiers to receive the preamplifier output signal of the first of the two selected preamplifiers.

The SAR ADC 100 may further comprise a SAR engine 106 configured to receive the primary latch output signal from the primary latch comparator 103 and the secondary latch output signal from the secondary latch comparator 104. The SAR engine 160 may be configured to generate a digital output code representative of the analog input signal based on the primary latch output signal and the secondary latch output signal. That is, the final digital output code that comprises a plurality of bits will be based on signals received from both the primary latch comparator 103 and the secondary latch comparator 104.

The SAR engine 106 is further configured to use only one of the latch output signals to determine each bit of the plurality of bits. The SAR engine 106 is further configured to use the secondary latch output signal to determine at least the MSB. Thus, for each bit, the SAR ADC 100 may be configured to determine whether a given bit is to be processed by the primary or the secondary latch comparator 103,104 (or any additional latch comparators, as discussed below). In one or more embodiments, the determination may be made dynamically based on a comparison of signal amplitudes for each bit to an acceptable signal amplitude threshold value.

In one or more embodiments, the SAR engine 106 may be an asynchronous SAR engine.

In other embodiments, whether the ADC engine 106 uses the primary latch comparator 104, the secondary latch comparator or any other latch comparator may be predetermined for each bit. In one or more embodiments, for example, the SAR engine 106 may be configured to use the secondary latch output signal to determine the I most significant bits of the plurality of bits, wherein I is greater than one and less than the number of bits in the plurality of bits. That is, in one or more embodiments, the SAR engine 106 may be configured to use the primary latch output signal for determining at least one of the bits of the plurality of bits. The predetermination of which latch comparator is used for each bit may be user selected or it may be based on the device in which the SAR ADC is being used. Thus, the SAR ADC of the present disclosure may provide for a flexible SAR ADC which can be adjusted or otherwise tailored in order to meet user or specification needs related to the trade-off between speed, power and accuracy.

In one or more embodiments of the present disclosure, the preamplifier circuit 102 may comprise at least three preamplifiers. The preamplifier circuit may further comprise a tertiary latch comparator 105 configured to receive a preamplifier output signal from a preamplifier later in the serially arranged plurality of preamplifiers that is arranged after the preamplifier from which the secondary latch comparator 104 receives a preamplifier output signal. That is, the tertiary latch comparator 105 may be arranged downstream from the secondary latch comparator 104. The tertiary latch comparator 105 may be configured to compare the received preamplifier output signal to a tertiary reference voltage and, based on the comparison, generate a tertiary latch output signal. The tertiary latch comparator 105 may be configured to provide the tertiary latch output signal to the SAR engine 106 for the J most significant bits, wherein M is at least equal to 1 and wherein M is at most equal to N-I, where N is the number of bits in the plurality of bits. That is, the tertiary latch output signal provided by the tertiary latch comparator 105 may be used by the SAR engine 106 for bits after the I most significant bits. The bits for which the tertiary latch output signal is used may be the remainder of the bits, or it may be a subset of the remaining bits. The number of bits processed by the tertiary latch comparator 106 may be the J bits. The J bits processed by the tertiary latch comparator 106 may be the bits which immediately follow the I bits processed by the secondary latch comparator 104.

In yet other embodiments, each preamplifier other than the final preamplifier 102D may comprise a latch comparator arranged thereafter such that each preamplifier other than the final latch comparator 102D is able to provide its preamplifier output signal to a corresponding latch comparator. Each respective latch comparator may be configured to receive the preamplifier output signal from its preceding preamplifier and to compare the received preamplifier output signal to a respective reference voltage. Based on the comparison, each latch comparator may be configured to provide a respective latch output signal to the SAR engine 106. Features and functionality described above with respect to the secondary or tertiary latch comparators 104, 105 may equally be applied to the additional latch comparators.

By providing a tertiary latch comparator 105 arranged between two of the preamplifiers, in instances where the signal amplitude of the preamplifier output signal output by the preamplifier arranged directly before the tertiary latch comparator 105 is sufficiently large, the tertiary latch comparator 105 may be used to generate the tertiary latch output signal instead of using the primary latch comparator 103. Taking this approach allows the preamplifiers after the preamplifier which provides the preamplifier output signal to the tertiary latch comparator 105 to be turned off or operated in a low power mode. Operation of one or more of the preamplifiers in a low power mode may comprise reducing a current provided to the latch comparators.

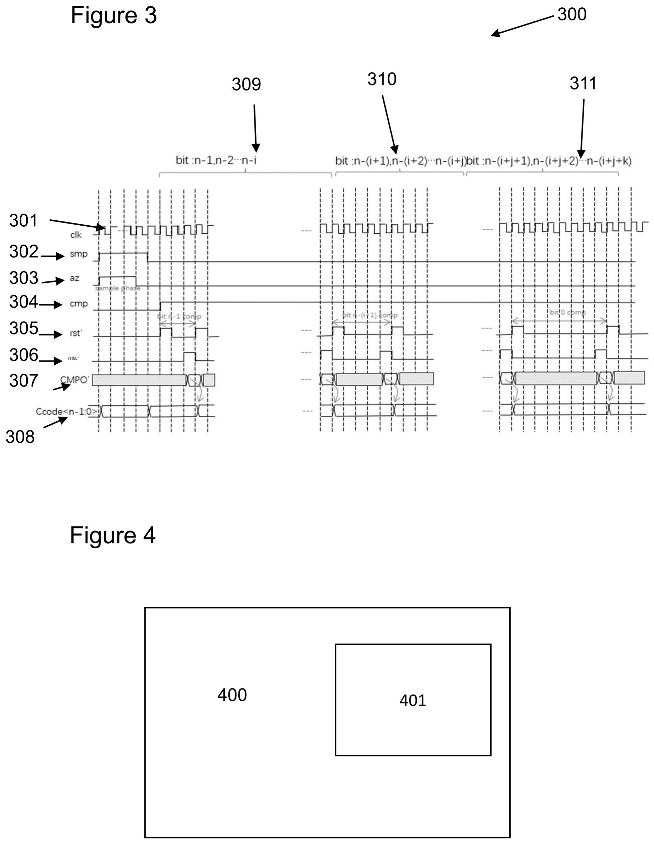

Figure 3 shows a timing diagram 300 that demonstrates the number of clock cycles taken for various processes during the operation of the SAR ADC. Note that an asynchronous solution that makes use of an asynchronous SAR engine can also be used where the bit timings do not depend on a clock. In an asynchronous solution, the preamplifiers and latches would be self-timed. The SAR engine would move from preamplification to latching based on a self-generated preamplifier timing and then move to the next bit decision when the latch signals its completion.

The first row 301 shows the clock signal of the SAR ADC as a repetitive signal that synchronises operations in the SAR ADC. Each rising or falling edge of the clock signal is able to trigger a specific action in the conversion process. In an asynchronous solution that makes use of an asynchronous SAR engine, the timing ratios might be similar but the specific actions of the conversion process (after sampling is complete) would be triggered by self-timed signals.

The second row 302 shows a sample signal which indicates when the analog input signal is being sampled. During the high state of this signal, the ADC may capture the analog input voltage. As described earlier, this may be achieved by way of a capacitor array or using a different approach.

The third row 303 shows an auto-zero (az) signal which may be used to calibrate the internal circuitry of the ADC to reduce or eliminate offset errors. When this signal is high, the ADC performs auto-zeroing.

The fourth row 304 shows a comparator signal which shows when the SAR ADC is operating in a comparison mode during which the n bit data decision is made.

The fifth row 305 shows preamplifier reset signals which are configured to reset the preamplifier and prepare the corresponding preamplifier for high-speed amplification of its input voltage. When the signal is high, the corresponding preamplifier is held in reset state. The reset signal may be set to high after the conversion of each bit of the multi-bit signal.

The sixth row 306 shows active low reset latch signals that are configured to hold the latch in a reset state until a comparison is to be performed. The rising edge of these signals trigger the corresponding latch to perform a comparison. The operating state of the latch comparators may also be controlled based on the reset latch signal.

The seventh row 307 shows the comparator output (CMPO) signals which indicate the result of the comparison at each bit level performed by the latch comparator being used for that bit. The transitions between high and low states represent whether the input voltage is higher or lower than the reference voltage at each step of the successive approximation process.

The eighth row 308 shows the Ccode = n-1:0 signal which indicates the digital output code after all of the bits have been determined through the successive approximation process. The notation <n-1:0> specifies that the code includes all bits from the MSB (bit n-1) to the LSB (bit 0).

The timing diagram 300 has been separated into three columns 309, 310, 311. The first column 309 is representative of the processing of bits n-1 (the MSB) to n-i (the I^{th} most significant bit, as described above). These bits may be processed by the secondary latch comparator 104 and may be processed over, for example, 3 clock cycles. The second column 310 shows bits n-(i+1) to n-(i+j), which are the N+1^{th} and I+J^{th} bits, as described above. These bits may be processed by the tertiary latch comparator 105 over, for example, 5 clock cycles. The third column 311 shows bits n-(i+j+1) to n-(i+j+k). These bits may be processed by the primary latch comparator 103 (in embodiments which do not include further latch comparators) and may be processed over, for example, 8 clock cycles.

More generally, each latch comparator 103, 104, 105 may be configured to compare the received amplified output signal to a respective reference voltage over one or more clock cycles in order to generate its latch output signal. The primary latch comparator 103 may compare the received amplified output signal to the primary reference voltage over more clock cycles than the secondary latch comparator 104 compares the received amplified output signal to the secondary reference voltage. Similarly, the tertiary latch comparator 105 may compared the received amplified output signal to the primary reference voltage over more clock cycles than the secondary latch comparator and over fewer clock cycles than the primary latch comparator 103. Thus, out of all of the latch comparators, 103, 104, 105 the secondary latch comparator 104 may compare its received amplified output signal to the secondary reference voltage over fewer clock cycles than any of the other latch comparators 103, 105 since the secondary latch comparator 104 deals with the MSB and, optionally, the N most significant bits.

Figure 4 shows an example device 400 comprising the SAR ADC 401 of any preceding claim. The device 400 may be any suitable electronic device that benefits from an SAR ADC 401. For example, the device 400 may be a vehicle such as an automobile, a smartphone or tablet computer, a medical device such as a computer monitoring system, a consumer electronic device such as a digital camera, audio equipment or gaming console, an Internet of Things (IoT) device or another type of electronic product.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A successive approximation register analog-to-digital converter, SAR ADC, configured to convert a received analog input signal into a digital output signal comprising a plurality of bits, the plurality of bits comprising bits from a Most Significant Bit (MSB) to a Least Significant Bit (LSB) comprising:
a digital-to-analog converter (DAC) configured to convert the received analog signal into an DAC output signal;
a pre-amplifier circuit comprising a plurality of serially arranged preamplifiers, wherein:
each preamplifier is configured to apply a gain to a signal received at its input node;
a first pre-amplifier of the plurality of preamplifiers is configured to receive the DAC output signal from the DAC at its input node and provide a first pre-amplifier output signal at an output node of the first pre-amplifier;
each other pre-amplifier of the plurality of preamplifiers is configured to receive an output signal from the preceding preamplifier in the serially arranged plurality of preamplifiers; and
a final pre-amplifier of the plurality of preamplifiers is configured to provide a final preamplifier output signal at an output node of the preamplifier circuit;
a primary latch comparator configured to receive the final preamplifier output signal from the output node of the pre-amplifier circuit and wherein the primary latch comparator is configured to compare the received final preamplifier output signal to a primary reference voltage and wherein the primary latch comparator is further configured to generate a primary latch output signal based on the comparison;
a secondary latch comparator configured to receive a preamplifier output signal from one of the plurality of pre-amplifiers other than the final preamplifier and wherein the secondary latch comparator is configured to compare the received preamplifier output signal to a secondary reference voltage and wherein the secondary latch comparator is further configured to generate a secondary latch output signal based on the comparison;
an SAR engine configured to receive the primary latch output signal from the primary latch comparator and the secondary latch output signal from the secondary latch comparator and further configured to generate a digital output code representative of the analog input signal based on the primary latch output signal and the secondary latch output signal,
wherein the SAR engine is configured to use only one of the latch output signals to determine each bit of the plurality of bits and wherein the SAR engine is configured to use the secondary latch output signal to determine at least the MSB.

2. The SAR ADC of claim 1 wherein the secondary latch comparator is configured to receive the first preamplifier signal from the first preamplifier.

3. The SAR ADC of any preceding claim wherein the SAR engine is configured to use the secondary latch output signal to determine the I most significant bits of the plurality of bits wherein I is greater than one and less than the number of bits in the plurality of bits.

4. The SAR ADC of claim 3 wherein:
the pre-amplifier circuit further comprises at least three pre-amplifiers;
the SAR ADC further comprises a tertiary latch comparator configured to receive a preamplifier output signal from a preamplifier later in the serially arranged plurality of preamplifiers that is arranged after the preamplifier from which the secondary latch comparator receives a preamplifier output signal and wherein the tertiary latch comparator is configured to compare the received preamplifier output signal to a tertiary reference voltage; and wherein the tertiary latch comparator is further configured to generate a tertiary latch output signal based on the comparison; and
wherein the tertiary latch comparator is configured to provide the tertiary latch output signal to the SAR engine for the J next-most significant bits, wherein M is at least equal to 1 and wherein M is at most equal to N-I, wherein N is equal to the number of bits in the plurality of bits.

5. The SAR ADC of any preceding claim wherein, for each bit for which the SAR engine uses the secondary latch output signal, one or more of the pre-amplifiers arranged after the preamplifier from which the preamplifier output signal is received by the secondary latch comparator are configured to operate in a low-power mode.

6. The SAR ADC of claim 5 wherein, for each bit for which the SAR engine uses the secondary latch output signal, current is diverted from one or more of the preamplifiers that are configured to operate in a low-power mode to the secondary latch comparator

7. The SAR ADC of any of claims 3 - 6 wherein, for each bit for which the SAR engine uses the tertiary latch output signal, one or more of the pre-amplifiers arranged after the preamplifier from which the preamplifier output signal is received by the tertiary latch comparator are configured to operate in a low-power mode.

8. The SAR ADC of any preceding claim wherein each latch comparator is configured to compare the received amplified output signal to a respective reference voltage over one or more clock cycles in order to generate the latch output signal, wherein the primary latch comparator compares the received amplified output signal to the primary reference voltage over more clock cycles than the secondary latch comparator compares the received amplified output signal to the secondary reference voltage.

9. The SAR ADC of any preceding claim wherein the DAC comprises one or more redundant bits.

10. The SAR ADC of any preceding claim wherein the DAC is a capacitive digital-to-analog converter.

11. The SAR ADC of any preceding claim wherein the SAR engine is an asynchronous SAR engine.

12. A device comprising the SAR ADC of any preceding claim.
